# EUROPEAN PATENT APPLICATION

(11) **EP 1 662 566 A2**
(43) Date of publication of application: **31.05.2006**
(21) Application number: 05257092.6
(22) Date of filing: 17.11.2005
(51) Int. Cl.: H01L 23/48, H01L 23/31

(54) **Semiconductor device and method of fabricating the same**

(30) Priority: 25.11.2004 JP 2004340041
(71) Applicant: SHINKO ELECTRIC INDUSTRIES CO., LTD., Nagano-shi, Nagano 381-2287 (JP)
(72) Inventor: Koizumi, Naoyuki c/o Shinko Electric Ind. Co., Ltd, Nagano-shi, Nagano 381-2287 (JP)
(74) Representative: Fenlon, Christine Lesley

(57) **Abstract**

A conductor layer (13) is formed on one surface of a semiconductor substrate (11) having a functional element formed therein, with an insulating layer (12) interposed therebetween, and a through hole (TH1) is then formed at a predetermined position in the semiconductor substrate. Furthermore, a support sheet is attached to the other surface of the semiconductor substrate (11), and the conductor layer (13) and the top of the support sheet are connected using a wire (14). A portion in which the conductor layer (13), the wire (14) and the through hole (TH1) are formed is sealed with resin (16), and the support sheet is removed. Furthermore, a conductor layer (15) is formed on an end portion (14a) of the wire (14) which is exposed from the other surface of the semiconductor substrate (11).

## Description

### BACKGROUND OF THE INVENTION

### (a) Field of the Invention

The present invention relates to a semiconductor device and a method of fabricating the same. In particular, the present invention relates to a semiconductor device having a structure adapted to ensure electrical conduction between the top and bottom surfaces of a semiconductor chip having a functional element (device) formed therein, and also to a method of fabricating the same.

It should be noted that in the description below, unless otherwise defined, a "semiconductor chip" means not only an individual device which has been cut and divided from a semiconductor wafer, but also an individual functional element (semiconductor element) which is formed in a semiconductor wafer and which has not yet been cut and divided from a semiconductor wafer.

### (b) Description of the Related Art

In recent years, with the demand for miniaturization of electronic instruments and devices, attempts have been made to miniaturize and densify semiconductor devices used in the electronic instruments and devices. Accordingly, semiconductor devices such as chip-scale packages (CSPs) have been developed and fabricated in which miniaturization is achieved by bringing the shape of a semiconductor device as close as possible to the shape of an individual semiconductor chip. Meanwhile, semiconductor devices such as stacked CSPs have been commercialized in which semiconductor chips are stacked in multiple layers in order to achieve higher densities. In a typical stacked CSP, for example, two semiconductor chips are stacked to be mounted on an insulating substrate of polyimide resin or the like, and terminals of each chip and terminals on the substrate are connected by wire bonding. Furthermore, the wires and the chips are sealed with resin, and the back surface thereof has a terminal structure of a ball grid array (BGA) type. This structure requires an additional space for wire bonding to the terminals on the substrate, around a chip mount area in the package.

In the case where a semiconductor device including a semiconductor element (device) is used as an interposer, another semiconductor chip or an electronic component mounted on this interposer needs to be electrically connected via the interposer to a substrate (mother board, printed circuit board, or the like) for mounting the interposer, or to another semiconductor chip or the like placed under the interposer. Namely, the interposer (semiconductor device) must have a structure which enables electrical conduction between the top and bottom surfaces thereof to be ensured.

Heretofore, through holes filled with plating have been typically used as means for ensuring electrical conduction between the top and bottom surfaces as described above. The purpose is to ensure electrical conduction between the two surfaces via the through holes (conductor filling the through holes) formed in the vertical direction at predetermined positions in the interposer. As methods of ensuring such electrical conduction, various methods have been proposed heretofore.

As one of such methods, for example, in the case of a silicon (Si) interposer, in a previously-proposed process, electrical conduction between the top and bottom surfaces of an interposer (semiconductor device) is ensured through the steps of: forming via holes in a surface of a silicon wafer having functional elements (devices) formed in the surface thereof; forming an insulating layer (e.g., a silicon nitride film or the like formed by CVD) in the via holes and on the surface of the wafer; forming a seed layer on the insulating layer and filling the via holes by copper (Cu) plating; planarizing the surface of the wafer; attaching a support body to the surface of the wafer; exposing the conductor (Cu) by polishing the back surface of the wafer; covering regions except the exposed conductor (Cu) with an insulating layer (e.g., a silicon nitride film or the like formed by CVD) and forming metal bumps on the conductor; removing the support body; and the like. Namely, a series of processes performed on the top surface of the wafer and a series of processes performed on the back surface of the wafer are required, and thus a relatively large number of steps are necessary.

A technology relating to such a process is also described, for example, in Japanese unexamined Patent Publication (JPP) 2004-221240.

In the previously-proposed method described above, in the case where a semiconductor device including a semiconductor element (device) is used as an interposer, electrical conduction between the top and bottom surfaces thereof needs to be ensured, and through holes filled with plating are used as typical means therefor. Furthermore, as a method for realizing this, as described above, a series of processes need to be performed on the top surface of a wafer, and further a series of processes need to be performed on the back surface of the wafer. Namely, a relatively large number of steps are necessary.

Accordingly, there has occurred a problem in that a fabrication period becomes relatively long and cost is consequently increased.

Moreover, in some steps of the above-described series of process steps, a relatively high temperature is applied (e.g., temperature becomes 300°C or more when an insulating layer such as a silicon nitride film is formed by CVD). Accordingly, there has been a risk of affecting devices formed in a substrate, e.g., a possibility of damaging characteristics of the devices. This results in a reduction in reliability on a product (semiconductor device) basis, and there is room for some improvement.

### SUMMARY OF THE INVENTION

Accordingly, it is desirable to provide a semiconductor device and a method of fabricating the same, in which a fabrication period and cost are reduced and which can contribute to an improvement in reliability on a product basis.

According to an embodiment of one aspect of the present invention, there is provided a semiconductor device including: a semiconductor substrate; a first conductor layer formed on one surface of the semiconductor substrate to be electrically connected to a functional element formed within the semiconductor substrate; and a second conductor layer formed on other surface of the semiconductor substrate, wherein the first and second conductor layers are connected via a through hole formed at a predetermined position in the semiconductor substrate by means of a bonding wire, and at least portions of the one surface of the semiconductor substrate in which the first conductor layer, the bonding wire, and the through hole are formed are covered with sealing resin.

Also, according to an embodiment of another aspect of the present invention, there is provided a method of fabricating a semiconductor device according to the above aspect. One aspect of the method includes the steps of: forming a first conductor layer on one surface of a semiconductor substrate with an insulating layer interposed therebetween, the semiconductor substrate having a functional element formed therein, the first conductor layer being electrically connected to the functional element; forming a through hole at a predetermined position in the semiconductor substrate; attaching a support sheet to an other surface of the semiconductor substrate; connecting the first conductor layer on the insulating layer and the support sheet in the through hole by means of a bonding wire; sealing, with sealing resin, at least portions of the one surface of the semiconductor substrate in which the first conductor layer, the bonding wire, and the through hole are formed; removing the support sheet; and forming a second conductor layer on an end portion of the bonding wire which is exposed from the other surface of the semiconductor substrate.

In a semiconductor device embodying the present invention and a method of fabricating the same, electrical conduction between the top and bottom surfaces can be ensured merely by forming the through hole at the predetermined position in the silicon substrate and connecting the two surfaces (between the first and second conductor layers) via the through hole using the wire without the need for a long process (a series of processes performed on the top surface of a wafer and a series of processes performed on the back surface of the wafer) as seen in prior art. Namely, a fabrication process can be simplified compared to that of the prior art. Accordingly, the fabrication period and cost can be reduced.

Furthermore, as described later in relation to preferred embodiments of the present invention, only a relatively low temperature (e.g., the temperature at which epoxy resin or the like used as a material for sealing the wire or the like is cured is approximately 200°C at most) is applied throughout the steps. Accordingly, a desired semiconductor device can be fabricated without any influence on functional elements formed in the substrate. This contributes to an improvement in reliability on a final product (semiconductor device) basis.

Also, according to an embodiment of still another aspect of the present invention, there is provided a method of fabricating a semiconductor device, including the steps of: forming a first conductor layer on one surface of a semiconductor substrate having a functional element formed therein, the first conductor layer being electrically connected to the functional element, and forming a conductor pattern on an other surface of the semiconductor substrate with an insulating layer interposed therebetween in such a manner that an opening portion formed at a predetermined position in the insulating layer is covered; forming a through hole at a position in the semiconductor substrate which corresponds to a region of the opening portion in the insulating layer; connecting the first conductor layer on the semiconductor substrate and the conductor pattern in the through hole by means of a bonding wire; sealing, with sealing resin, at least portions of the one surface of the semiconductor substrate in which the first conductor layer, the bonding wire, and the through hole are formed; and forming a second conductor layer on the conductor pattern exposed from the other surface of the semiconductor substrate.

According to a semiconductor device fabrication method embodying this aspect, a fabrication process can be further simplified compared to that of the semiconductor device fabrication method embodying the aforementioned aspect, because there is no need for a process for attaching a support sheet to the other surface of the silicon substrate and a process for removing this support sheet. This makes it possible to further reduce the fabrication period and cost.

### BRIEF DESCRIPTION OF THE DRAWINGS

FIG. 1 is a cross-sectional view schematically illustrating the structure of a semiconductor device according to a first embodiment of the present invention;
FIGs. 2A to 2E are cross-sectional views illustrating steps of a method of fabricating the semiconductor device of FIG. 1;
FIGs. 3A to 3E are cross-sectional views illustrating fabrication steps subsequent to those of FIGs. 2A to 2E;
FIGs. 4A to 4C are cross-sectional views illustrating various application examples of the semiconductor device of FIG. 1;
FIG. 5 is a cross-sectional view schematically illustrating the structure of a semiconductor device according to a second embodiment of the present invention;
FIGs. 6A to 6E are cross-sectional views illustrating (some of) steps of a method of fabricating the semiconductor device of FIG. 5;
FIGs. 7A to 7C are cross-sectional views illustrating various application examples of the semiconductor device of FIG. 5; and
FIG. 8 is a cross-sectional view schematically illustrating the structure of a semiconductor device according to a third embodiment of the present invention.

### DESCRIPTION OF THE PREFERRED EMBODIMENTS

Hereinafter, preferred embodiments of the present invention will be described with reference to the accompanying drawings.

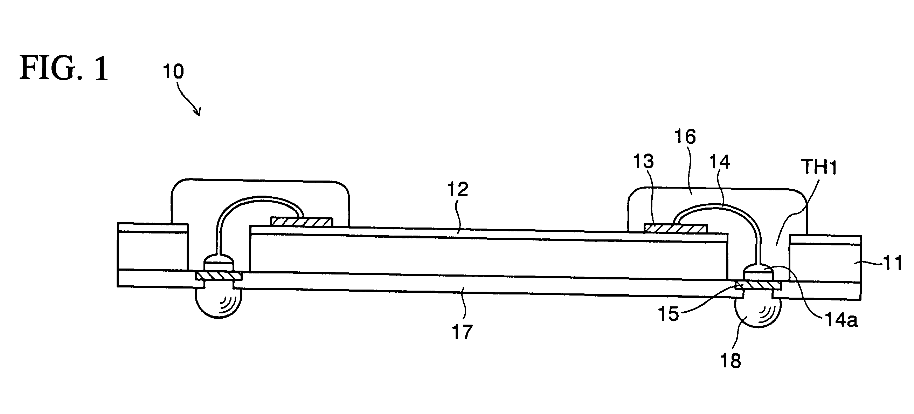

FIG. 1 schematically illustrates, in a cross-sectional view, the structure of a semiconductor device according to a first embodiment of the present invention.

The semiconductor device 10 according to this embodiment basically has a structure in which portions above and under through holes TH1 formed at predetermined positions in the silicon substrate 11 as illustrated in this drawing are connected by wire bonding via the through holes TH1. Furthermore, the semiconductor device 10 has the feature that it is possible to form a multilayered stack or to mount another chip component, a semiconductor device, or the like on the semiconductor device 10 using pads (conductor layer) or external connection terminals exposed from a protective film when necessary as described later.

The silicon substrate 11 corresponds to part of a wafer which is ultimately obtained by dividing the silicon wafer having a plurality of functional elements (devices) formed therein in advance into individual chips as described later. On one surface (upper surface in the illustrated example) of the silicon substrate 11, a passivation film 12 as an insulating layer (protective film) is formed. Furthermore, pads 13 are formed at predetermined positions on this passivation film 12. These predetermined positions correspond to the positions of electrodes (not shown) of the devices formed in the silicon substrate 11. Each pad 13 is electrically connected to the corresponding electrode.

To the pad 13, one end of the bonding wire 14 is connected. The other end (in the drawing, end portion 14a formed in a bump-like shape) of the bonding wires 14 is introduced into the through hole TH1 formed in the silicon substrate 11, and exposed at the other surface (lower surface in the illustrated example) of the silicon substrate 11. Furthermore, a barrier metal layer (conductor layer) 15 is formed on the end portion 14a of the bonding wire 14. Accordingly, the two surfaces (the pad 13 and the barrier metal layer 15) of the silicon substrate 11 are electrically connected via the bonding wire 14 in the through hole TH1.

Moreover, one surface (upper surface) of the silicon substrate 11 is sealed with sealing resin 16 in such a manner that a portion (including the regions of the pad 13 and the through hole TH1) in the vicinity of the bonding wire 14 is covered. Although in the illustrated example only the portion in the vicinity of the wire 14 is sealed, the whole of the one surface of the silicon substrate 11 may be covered with the sealing resin 16. Also, on the other surface (lower surface) of the silicon substrate 11, a solder resist layer 17 as an insulating layer (protective film) is formed so as to cover the entire surface with the barrier metal layer 15 being exposed. Furthermore, a solder ball 18 as an external connection terminal is bonded to the barrier metal layer 15 exposed from the solder resist layer 17.

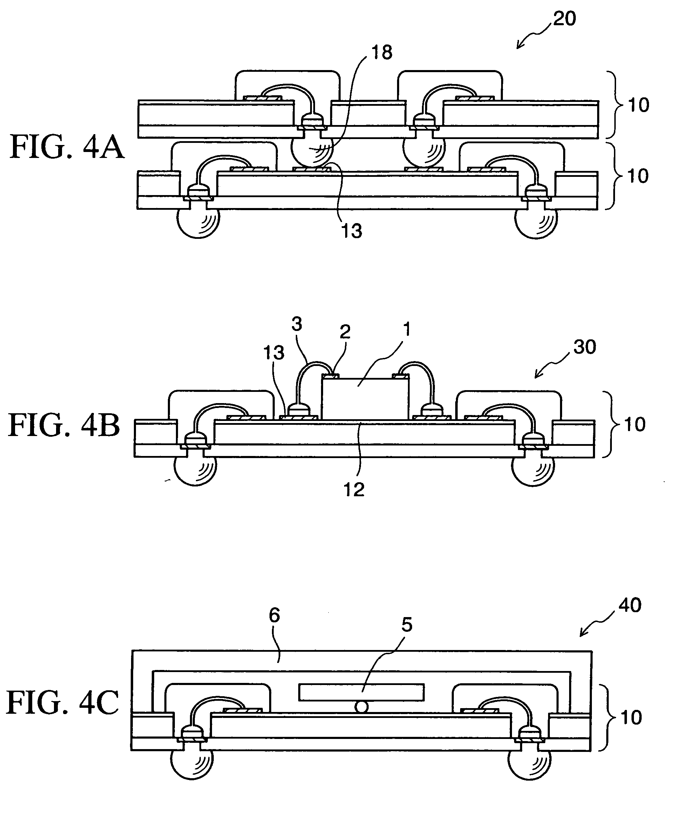

The material, size, and the like of each component of the semiconductor device 10 according to this embodiment will be described later in relation to a process. Furthermore, in the example illustrated in FIG. 1, illustrated is a situation in which all pads 13 on the passivation film 12 are covered with the sealing resin 16. However, since the pads 13 are respectively connected to the electrodes of the devices formed in the silicon substrate 11 as described previously, some of the pads 13 formed on the passivation film 12 are in exposed states (see FIGs. 4A to 4C) without being covered with the sealing resin 16, although not illustrated in FIG 1.

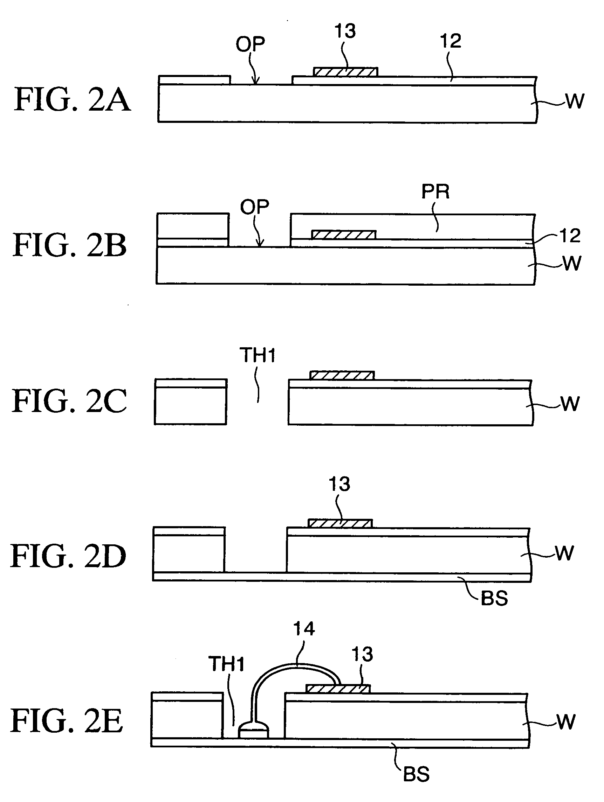

Next, a method of fabricating the semiconductor device 10 according to the first embodiment will be described with reference to FIGs. 2A to 3E illustrating one example of a fabrication process thereof. It should be noted that in the cross-sectional structure illustrated in each of these drawings, only a portion (region in which portions above and under a through hole are connected via the through hole by wire bonding) relating to an essential part thereof is illustrated for simplification of illustration.

To begin with, in the first step (FIG. 2A), a semiconductor substrate (silicon wafer W) having a plurality of functional elements (devices) formed therein is prepared. For example, a silicon wafer having a predetermined thickness (10 to 725 µm) and a plurality of devices formed therein in advance by a known method is prepared; the passivation film 12 made of silicon nitride (SiN), phosphosilicate glass (PSG), or the like is formed on the surface of the silicon wafer in which the devices are formed; then, the aluminum (A1) pads 13 connected to electrodes (not shown) formed on the devices are patterned on portions of the passivation film 12 which correspond to the positions of the electrodes, respectively; and further, portions of the passivation film 12 which correspond to predetermined positions are removed (formation of opening portions OP). These opening portions OP are portions which are used as guides when through holes are formed in a later step. The "predetermined positions" where the opening portions OP are to be formed are selected within portions in which the functional elements of the devices formed in the wafer are not formed. Thus, the silicon wafer W is obtained of which one surface is covered with the passivation film 12 having the opening portions OP in predetermined positions as illustrated in the drawing and in which the pads 13 are exposed at predetermined positions on the passivation film 12.

In the next step (FIG. 2B), a resist layer (mask) PR is formed on the surface of the silicon wafer W on which the passivation film 12 is formed, in such a manner that the opening portions OP are exposed. The thickness of the resist layer PR is approximately 1 to 100 µm. As the material thereof, photoresist (liquid one or film-type one (dry film)) is typically used. For example, in the case where liquid photoresist is used, the resist layer PR is formed through a series of steps including surface cleaning, resist application to the surface, drying, exposure, and development. On the other hand, in the case where dry film resist is used, the resist layer PR is formed through a series of steps including surface cleaning, pretreatment (removal of a separator sheet) prior to lamination, resist lamination in the atmosphere, exposure, cover sheet removal, and development, because dry film resist typically has a structure in which resist material is interposed between a cover sheet of polyester and a separator sheet of polyethylene.

In the next step (FIG. 2C), using the resist layer PR (FIG. 2B) as a mask, the through holes TH1 are formed in the silicon wafer W, for example, by dry etching such as reactive ion etching (RIE), ICP plasma, or sputtering, or wet etching. Namely, the through holes TH1 are formed at predetermined positions in device formation regions in the silicon wafer W.

At this time, the sizes of the through holes TH1 formed are determined depending on the thickness (chip thickness after being ultimately divided into individual chips) of the silicon wafer W and whether a "capillary" can be inserted therein with space left over when wire bonding is performed in a later step. Namely, bonding can be performed if a capillary does not come into contact with the inner wall portion (i.e., chip portion) of a through hole TH1 when the capillary is inserted into the through hole TH1. However, there are capillaries having various shapes, and the widths of the cross-sectional shapes thereof generally increase toward the top portions. Accordingly, there are naturally limitations on the relationship between the thickness of the chip and the size of the through hole TH1. In this embodiment, the size of the through hole TH1 formed is selected to be 50 µm or more when the thickness of the chip is 10 to 725 µm, in consideration of the above-described factors.

As for the shape of the through hole TH1, variations such as "ellipse," "square," "rectangle", and the like are acceptable other than a normal "circle." Furthermore, as for the arrangement of the through holes TH1, a "peripheral type" in which the through holes TH1 are arranged only in a peripheral region of each chip or an "area array type" in which the through holes TH1 are arranged in the form of a matrix in the region of the chip can be adopted.

After the through holes TH1 have been formed at predetermined positions in the silicon wafer W as described above, the resist layer (mask) PR is removed, for example, using an alkaline solution.

In the next step (FIG. 2D), a support sheet BS is attached to the back surface (surface opposite to that where the pads 13 are exposed) of the silicon wafer W. As the support sheet BS, for example, a tape or a film made of conductive material (aluminum (Al), copper (Cu), or the like) and having adhesiveness on one surface is used, and attached to the wafer W in such a manner that the adhesive surface of the tape or film is faced toward the wafer W. Instead of such a conductive tape or film, an insulating film made of polyimide resin, various organic resins, or the like may be attached thereto. Alternatively, metal foil such as aluminum foil or copper foil may be merely pressed against the wafer W.

In the next step (FIG. 2E), the bottom surfaces (on the support sheet BS) of the through holes TH1 formed in the silicon wafer W and the pads 13 on the passivation film 12 are connected using the bonding wires 14 (wire bonding). This is performed by ball bonding (thermocompression bonding used in combination with ultrasonic waves). Namely, a tool tip (capillary holding a gold (Au) wire for bonding in a hollow portion thereof) of a wire bonder is inserted into a through hole TH1, and an Au ball melted at the tool tip is bonded to a bonding target portion heated in advance, by diffusion caused under heat and pressure and by friction due to ultrasonic vibration. The heating temperature at this time is approximately 150°C to 200°C.

In this case, in terms of the sequence for bonding the bonding wires 14, there are two methods: in a first method, bonding is first performed on the bottom surface of a through hole TH1 and then performed on the corresponding pad 13; in a second method, which is reverse to the first method, bonding is first performed on a pad 13 and then performed on the bottom surface of the corresponding through hole TH1. The present step is performed according to the former method (sequence in which the bonding of the bottom surface of a through hole TH1 is followed by that of the corresponding pad 13).

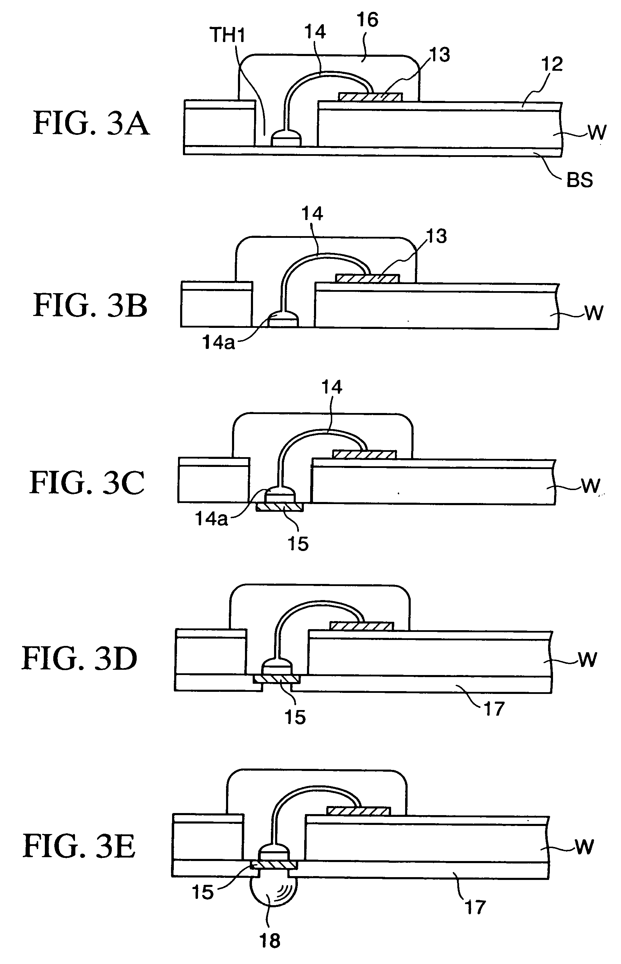

In the next step (FIG. 3A), on the surface of the silicon wafer W on which the passivation film 12 is formed, at least portions in which the bonding wires 14, the pads 13 and the through holes TH1 are formed are sealed with the sealing resin 16. This resin sealing can be performed using known means such as a molding die. As the material of the sealing resin 16, thermosetting resin such as epoxy resin or acrylic resin having high adhesiveness is preferably used. The temperature at which such resin is cured is approximately 200°C. It should be noted that although in this step only portions in the vicinities of the wires 14 are covered with the sealing resin 16 as illustrated in the drawing, the entire upper surface of the silicon wafer W may be covered with the sealing resin 16.

In the next step (FIG. 3B), the support sheet BS (FIG. 3A) is removed by stripping-off (in the case of a tape or a film) or by wet etching (in the case of metal foil). Thus, the end portions 14a (Au portions formed in bump-like shapes) of the bonding wires 14 are exposed from the back surface (surface opposite to that where the pads 13 are formed) of the silicon wafer W.

In the next step (FIG. 3C), the surfaces of the end portions 14a (Au) of the bonding wires 14 which are exposed from the back surface of the silicon wafer W are plated with nickel (Ni) and gold (Au), thus forming the barrier metal layer 15 having a two-layer structure (Ni/Au).

In the next step (FIG. 3D), the solder resist layer 17 is formed so as to cover the entire surface (back surface) of the silicon wafer W in such a manner that the barrier metal layer 15 formed on the back surface of the silicon wafer W is exposed. This solder resist layer 17 can be formed by photolithography technology as in the process performed when the resist layer (mask) PR has been formed in the step of FIG. 2B.

In the final step (FIG. 3E), the solder balls 18 provided as external connection terminals are mounted on the barrier metal layer (plated Ni/Au layer) 15 exposed from the solder resist layer 17, and are bonded thereto by reflow. Subsequently, the silicon wafer W is cut and divided into individual chips (semiconductor devices) by a dicer or the like, although not particularly illustrated. By the above-described steps, the semiconductor device 10 according to this embodiment is fabricated.

As described above, according to the semiconductor device 10 (FIG. 1) of this embodiment and the method (FIGs. 2A to 3E) of fabricating the same, electrical conduction between the top and bottom surfaces can be ensured merely by forming the through holes TH1 at predetermined positions in a device formation region of the silicon substrate 11 (silicon wafer W) and connecting the two surfaces (between the pads 13 and the barrier metal layer 15) via the through holes TH1 using the wires 14 without the need for a long process as seen in prior art. Namely, a fabrication process can be simplified compared to that of the previously-proposed process. Accordingly, a fabrication period and cost can be reduced.

Moreover, in the fabrication method according to this embodiment, only a relatively low temperature is applied throughout the steps. Accordingly, a desired semiconductor device 10 can be fabricated without any influence on each device formed in the substrate 11 (wafer W). Namely, the heating temperature at which the wires 14 are bonded to the pads 13 and the like in the step of FIG. 2E is approximately 150°C to 200°C, and the temperature at which epoxy resin or the like used as a material for sealing the wires 14 and the like is cured in the step of FIG. 3A is approximately 200°C at most. Accordingly, it is possible to eliminate the disadvantage in that characteristics of a device may be damaged because of a high temperature (300°C or more) at the time of the formation of an insulating film such as a silicon nitride film by CVD, as seen in the previously-proposed process. This contributes to an improvement in reliability on a final product (semiconductor device 10) basis.

Furthermore, when necessary, the semiconductor device 10 of this embodiment can be stacked in multiple layers using the pads 13 or the external connection terminals 18 exposed from the protective film 12 or 17. In this case, the overall size can be reduced compared to that of a general stacked CSP if chip sizes are equal, because the two surfaces of each chip (semiconductor device 10) stacked are connected via the through holes TH1 in the chip by wire bonding. Namely, a general stacked CSP requires terminals on a substrate and an additional space for wire bonding around a chip mount area in the package, and therefore the size tends to be large; meanwhile, the semiconductor device 10 according to this embodiment does not require such an additional space, and therefore the overall size can be reduced.

FIGs. 4A to 4C schematically illustrate, in cross-sectional views, various application examples of the semiconductor device 10 (FIG. 1) according to the above-described embodiment.

First, FIG. 4A illustrates a structural example (semiconductor device 20) for the case where semiconductor devices 10 according to the embodiment of FIG. 1 are used in a state in which they are stacked in multiple layers. In this structural example, the external connection terminals (solder balls) 18 of the upper semiconductor device 10 are electrically connected to the pads 13 of the lower semiconductor device 10. Furthermore, although not illustrated in the drawing, underfill resin such as epoxy resin is filled into the space between the two devices 10 and thermally cured, whereby the two devices 10 are bonded together. Although semiconductor devices 10 are stacked in two layers in the illustrated example, it is a matter of course that the number of layers to be stacked is not limited to two. Namely, the number of layers to be stacked can be appropriately selected according to the function required for a semiconductor device to be formed as a stacked structure.

FIG. 4B illustrates a structural example (semiconductor device 30) for the case where the semiconductor device 10 according to the embodiment of FIG. 1 is used with another chip component mounted thereon. In this structural example, the chip component 1 is fixed on the semiconductor device 10 (passivation film 12) using an adhesive or the like in a state in which the back surface (surface opposite to that where electrodes 2 are formed) of the chip component 1 is faced down, and then the electrodes 2 of the chip component 1 and the pads 13 of the semiconductor device 10 are electrically connected using bonding wires 3. Furthermore, although not illustrated in the drawing, resin sealing is performed so that the entire structure (at least portions in which conductor portions such as the wires 3 are exposed) is covered.

FIG. 4C illustrates a structural example (semiconductor device 40) for the case where the semiconductor device 10 (FIG. 1) according to the embodiment of FIG. 1 is applied to a microelectro-mechanical system (MEMS). In this structural example, a chip component 5 (e.g., a MEMS product used in medical equipment, a household electrical appliance, measurement equipment, or the like) which has a mechanoelectrical transduction function and which has a workable portion is mounted on the semiconductor device 10, and further, the workable portion of this chip component 5 is sealed with a cap 6 for protection.

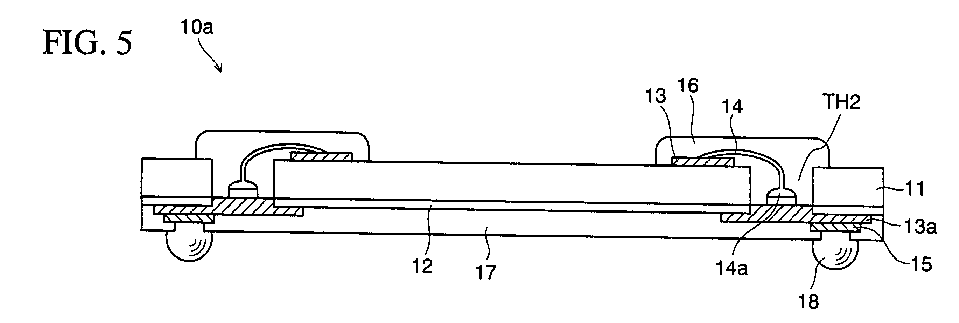

FIG. 5 schematically illustrates, in a cross-sectional view, the structure of a semiconductor device according to a second embodiment of the present invention.

Similar to the semiconductor device 10 (FIG. 1) according to the first embodiment, the semiconductor device 10a according to the second embodiment includes a structure (structure in which portions above and under through holes TH2 formed at predetermined positions in a device formation region are connected via the through holes TH2 by wire bonding) which characterizes the present invention.

In comparison with the case of the first embodiment (FIG. 1), the difference in structure is that the surface (i.e., the surface of the silicon substrate 11 in which a functional element (device) is formed) on which the passivation film 12 is formed is placed on the vertically opposite side to that in the case of the first embodiment (FIG. 1) and covered with the solder resist layer 17. Accordingly, the pad 13 to which one end of the bonding wire 14 is connected is formed directly on the silicon substrate 11, and the other end (end portion 14a) of the bonding wire 14 is electrically connected to the barrier metal layer 15 via a conductor layer 13a which is formed on the passivation film 12 so as to include the opening region of the through hole TH2. Other components are basically the same as those in the case of the first embodiment (FIG. 1), and therefore will not be further described.

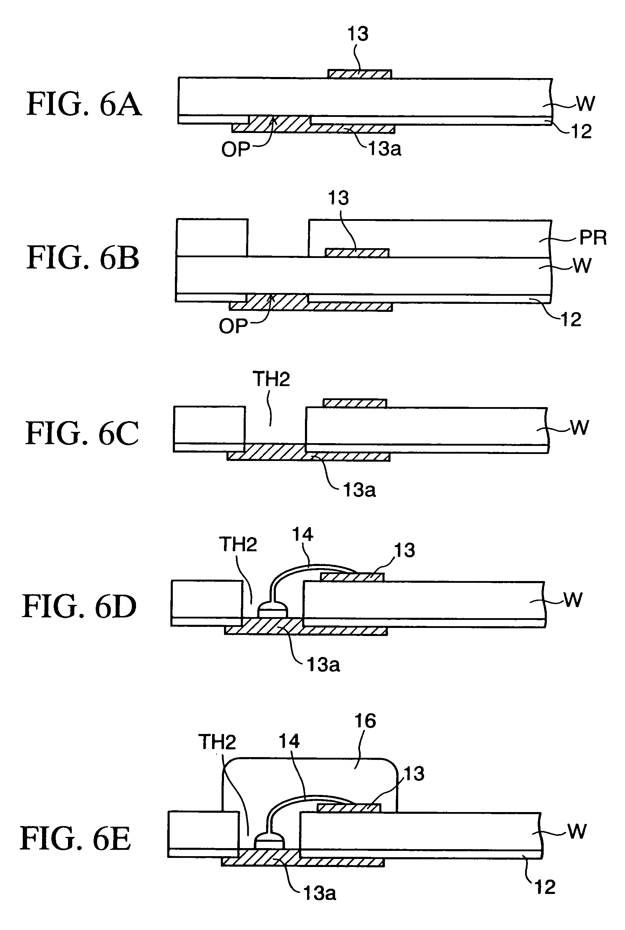

Hereinafter, a method of fabricating the semiconductor device 10a according to this embodiment will be described with reference to FIGs 6A to 6E illustrating (part of) one example of a fabrication process thereof. As in the case of the first embodiment (FIGs. 2A to 3E), only a portion (a region in which portions above and under a through hole are connected via the through hole by wire bonding) relating to an essential part thereof is illustrated in the illustrated cross-sectional structures.

To begin with, in the first step (FIG. 6A), a silicon wafer W having a plurality of functional elements (devices) formed therein is prepared as in the aforementioned process performed in the step of FIG 2A. Namely, a silicon wafer having a predetermined thickness (10 to 725 µm) and a plurality of devices formed therein in advance by a known method is prepared; the passivation film 12 made of silicon nitride (SiN) or the like is formed on the surface of the silicon wafer in which the devices are formed; and then, portions of the passivation film 12 which correspond to predetermined positions are removed (formation of opening portions OP). These opening portions OP are portions which are used as guides when through holes are formed in a later step. The "predetermined positions" where the opening portions OP are to be formed are selected within portions in which the functional elements of the devices formed in the wafer are not formed. Furthermore, on the passivation film 12, the conductor layer 13a of, for example, aluminum (Al) is patterned so as to include the regions of the opening portions OP and portions corresponding to the positions of electrodes (not shown) formed on the devices. On the opposite surface (on the silicon wafer W) to the side where the passivation film 12 is formed, the pads 13 are similarly patterned.

In the next step (FIG. 6B), as in the aforementioned process performed in the step of FIG. 2B, a resist layer (mask) PR is formed to a thickness of approximately 1 to 100 µm on the surface of the silicon wafer W on which the pads 13 are formed, in such a manner that portions corresponding to the regions of the opening portions OP of the passivation film 12 are exposed.

In the next step (FIG. 6C), as in the aforementioned process performed in the step of FIG. 2C, the through holes TH2 (in the illustrated embodiment, "via holes" reaching the conductor layer 13a) are formed in the silicon wafer W by dry etching, wet etching, or the like using the resist layer PR (FIG. 6B) as a mask. The sizes, shapes, and arrangement of the through holes TH2 formed are the same as those for the case of the aforementioned first embodiment. After the through holes TH2 are formed at predetermined positions in device formation regions in the silicon wafer W, the resist layer (mask) PR is removed using an alkaline solution.

In the next step (FIG. 6D), as in the aforementioned process performed in the step of FIG. 2E, the bottom surfaces of the through holes TH2 formed in the silicon wafer W and the pads 13 on the silicon wafer W are connected by ball bonding using the bonding wires 14. The sequence for bonding the bonding wires 14 is the same as that for the case of the aforementioned first embodiment.

In the next step (FIG. 6E), as in the aforementioned process performed in the step of FIG. 3A, on the surface of the silicon wafer W on which the pads 13 are formed, at least portions in which the bonding wires 14, the pads 13 and the through holes TH2 are formed are sealed with the sealing resin 16. Alternatively, the entire upper surface of the silicon wafer W may be covered with the sealing resin 16.

Although steps subsequent to this step are not particularly illustrated, as in the aforementioned process performed in the steps of FIGs. 3C to 3E, the barrier metal layer 15 is formed on the conductor layer 13a exposed from the back surface (passivation film 12) of the silicon wafer W; the solder resist layer 17 is formed so as to cover the entire surface (back surface) in such a manner that the barrier metal layer 15 is exposed; the solder balls (external connection terminals) 18 are further bonded to the barrier metal layer 15 exposed from the solder resist layer 17; and then the silicon wafer W is diced into individual chips (semiconductor devices). By the above-described steps, the semiconductor device 10a according to the second embodiment is obtained.

According to the semiconductor device 10a (FIG. 5) of this second embodiment and the method (FIGs. 6A to 6E) of fabricating the same, the fabrication process can be simplified as a whole compared to that for the case of the first embodiment (FIGs. 1 to 3E), because there is no need for a process (step of FIG. 2D) for attaching a support sheet BS to the back surface of the silicon wafer W and a process (step of FIG. 3B) for removing the support sheet BS. This makes it possible to further reduce a fabrication period and cost. Other advantages are the same as those for the case of the first embodiment.

Moreover, although in the first embodiment (FIG. 1) the end portions 14a of the bonding wires 14 are connected directly to the barrier metal layer 15 exposed from the lower surface of the silicon substrate 11, in this second embodiment (FIG. 5), the end portions 14a of the bonding wires 14 are connected to the barrier metal layer 15 via the conductor layer 13a which is formed on the passivation film 12 so as to include opening regions of the through holes TH2. Accordingly, airtightness between the top and bottom surfaces can be maintained. This characteristic structure is effective particularly in the case where it is applied to a MEMS (microelectro-mechanical system).

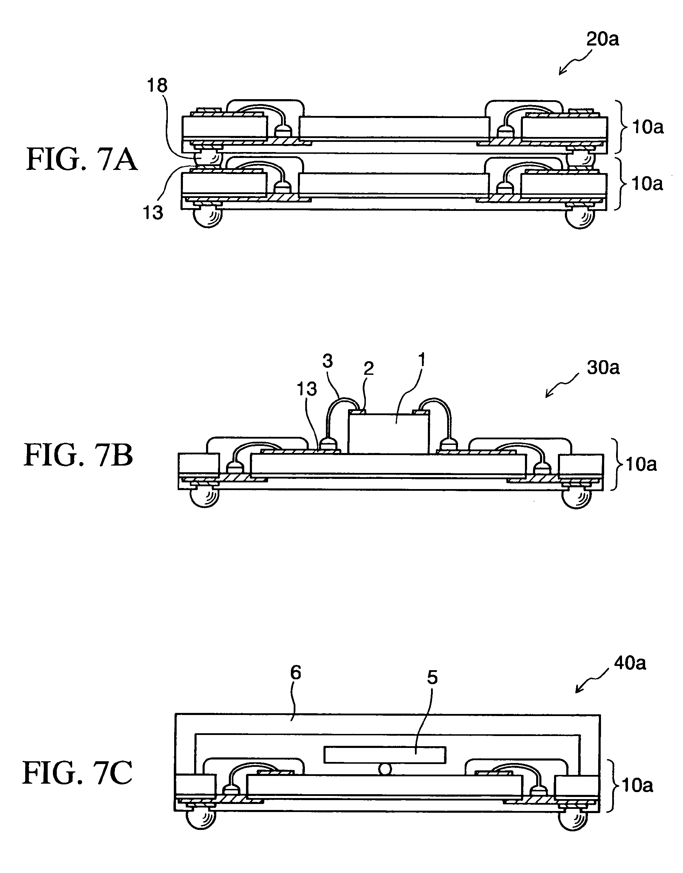

FIGs. 7A to 7C schematically illustrate, in cross-sectional views, various application examples of the semiconductor device 10a (FIG. 5) according to the second embodiment. In these drawings, the structures of semiconductor devices 20a, 30a, and 40a illustrated in FIGs. 7A to 7C are basically the same as those of the semiconductor devices 20, 30, and 40 illustrated in FIGs. 4A to 4C, respectively. Accordingly, the structures thereof will not be further described. It should be noted, however, that airtight sealing can be achieved by the above-described characteristic structure in the structural example (semiconductor device 40a having the MEMS product 5 mounted thereon) illustrated in FIG. 7C unlike the structural example (semiconductor device 40 having the MEMS product 5 mounted thereon) illustrated in FIG. 4C.

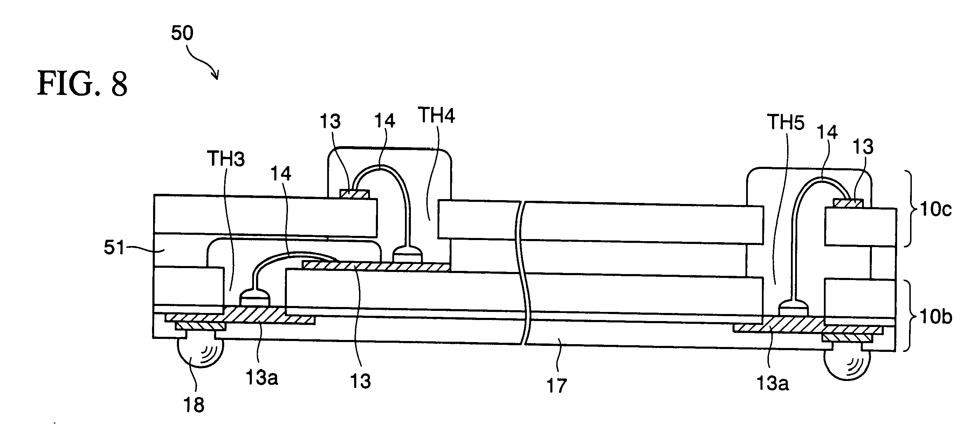

FIG. 8 schematically illustrates, in a cross-sectional view, the structure of a semiconductor device according to a third embodiment of the present invention.

Similar to the semiconductor devices 10 and 10a (FIGs. 1 and 5) according to the aforementioned first and second embodiments, the semiconductor device 50 according to this third embodiment includes the structure (structure in which portions above and under through holes TH3, TH4, and TH5 formed at predetermined positions in a device formation region are connected via the through holes TH3, TH4, and TH5 by wire bonding) which characterizes an embodiment of the present invention.

In comparison with the case of the first and second embodiments (FIGs. 1 and 5), the difference in structure is that two semiconductor chips (semiconductor devices 10b and 10c) are stacked in two layers with an adhesive layer 51 interposed therebetween. The structure of the lower chip (semiconductor device 10b) is basically the same as that for the case of the second embodiment (FIG. 5). In the structural example illustrated in FIG. 8, in the upper and lower chips 10c and 10b, portions (upper and lower pads 13) above and under the through holes TH4 are connected using bonding wires 14 in the through holes TH4, and portions (the pads 13 on the upper side and the conductor layer 13a on the lower side) above and under the through holes TH5 are connected using bonding wires 14 in the through holes TH5. Furthermore, in the lower chip 10b, portions (pads 13 and conductor layer 13a) above and under the through holes TH3 are connected using bonding wires 14 in the through holes TH3.

## Claims

1. A semiconductor device (10, 10a) comprising:
a semiconductor substrate (11);
a first conductor layer (13) formed on one surface of the semiconductor substrate to be electrically connected to a functional element formed within the semiconductor substrate; and
a second conductor layer (15) formed on an other surface of the semiconductor substrate,
wherein the first and second conductor layers are connected via a through hole (TH1, TH2) formed at a predetermined position in the semiconductor substrate by means of a bonding wire (14), and at least portions of the one surface of the semiconductor substrate in which the first conductor layer, the bonding wire and the through hole are formed are covered with sealing resin (16).

2. The semiconductor device according to claim 1, wherein a protective film (17) is formed on the other surface of the semiconductor substrate (11) with the second conductor layer (15) being exposed, and an external connection terminal (18) is bonded to the second conductor layer exposed from the protective film.

3. A semiconductor device (20, 20a) comprising a predetermined number of semiconductor devices (10, 10a) according to claim 2, wherein the predetermined number of semiconductor devices are electrically connected via the first conductor layer (13) and the external connection terminal (18), and are stacked.

4. A semiconductor device (30, 30a) comprising the semiconductor device (10, 10a) according to claim 2, wherein a chip component (1) is mounted on the semiconductor device while being electrically connected to the first conductor layer (13).

5. A semiconductor device (40, 40a), comprising the semiconductor device (10, 10a) according to claim 2, wherein a chip component (5) having a mechanoelectrical transduction function and a workable portion is mounted on the semiconductor device, and further sealed with a cap (6) for protecting the workable portion of the chip component.

6. A method of fabricating a semiconductor device, comprising the steps of:
forming a first conductor layer (13) on one surface of a semiconductor substrate (W) with an insulating layer (12) interposed therebetween, the semiconductor substrate having a functional element formed therein, the first conductor layer being electrically connected to the functional element;
forming a through hole (TH1) at a predetermined position in the semiconductor substrate;
attaching a support sheet (BS) to an other surface of the semiconductor substrate;
connecting the first conductor layer on the insulating layer and the support sheet in the through hole by means of a bonding wire (14);
sealing, with sealing resin (16), at least portions of the one surface of the semiconductor substrate in which the first conductor layer, the bonding wire and the through hole are formed;
removing the support sheet (BS); and
forming a second conductor layer (15) on an end portion (14a) of the bonding wire which is exposed from the other surface of the semiconductor substrate (W).

7. The method according to claim 6, further comprising the steps of:
forming a protective film (17) on the other surface of the semiconductor substrate with the second conductor layer (15) being exposed; and
bonding an external connection terminal (18) to the second conductor layer exposed from the protective film and then dividing the semiconductor substrate into individual chips.

8. The method according to claim 6 or 7, wherein the position at which the through hole (TH1) is formed is selected within a portion (OP) of the semiconductor substrate (W) in which the functional element is not formed.

9. A method of fabricating a semiconductor device, comprising the steps of:
forming a first conductor layer (13) on one surface of a semiconductor substrate (W) having a functional element formed therein, the first conductor layer being electrically connected to the functional element, and forming a conductor pattern (13a) on an other surface of the semiconductor substrate with an insulating layer (12) interposed therebetween in such a manner that an opening portion (OP) formed at a predetermined position in the insulating layer is covered;
forming a through hole (TH2) at a position in the semiconductor substrate which corresponds to a region of the opening portion in the insulating layer;
connecting the first conductor layer on the semiconductor substrate and the conductor pattern in the through hole by means of a bonding wire (14);
sealing, with sealing resin (16), at least portions of the one surface of the semiconductor substrate in which the first conductor layer, the bonding wire and the through hole are formed; and
forming a second conductor layer (15) on the conductor pattern exposed from the other surface of the semiconductor substrate (W).

10. The method according to claim 9, further comprising the steps of:
forming a protective film (17) on the other surface of the semiconductor substrate with the second conductor layer (15) being exposed; and
bonding an external connection terminal (18) to the second conductor layer exposed from the protective film, and then dividing the semiconductor substrate into individual chips.

11. The method according to claim 9 or 10, wherein the position at which the through hole (TH2) is formed is selected within a portion (OP) of the semiconductor substrate (W) in which the functional element is not formed.
